# EUROPEAN PATENT SPECIFICATION

(11) **EP 3 399 321 B1**
(45) Date of publication and mention of the grant of the patent: **20.07.2022**
(21) Application number: 18169718.6
(22) Date of filing: 27.04.2018
(51) Int. Cl.: G01R 29/08, B66C 15/06, G08B 21/02

(54) **SYSTEM AND METHOD FOR VOLTAGE DETECTION FOR EQUIPMENT**
SYSTEM UND VERFAHREN ZUR SPANNUNGSERFASSUNG FÜR AUSRÜSTUNG
SYSTÈME ET PROCÉDÉ DE DÉTECTION DE TENSION POUR UN ÉQUIPEMENT

(30) Priority: 28.04.2017 US 201762491697 P
(43) Date of publication of application: 07.11.2018
(73) Proprietor: Greenlee Tools, Inc., Rockford, IL 61109 (US)
(72) Inventor: McNulty, William John, Washington, DC District of Columbia 20007 (US); Standiford, Michael, Libertyville, IL Illinois 60048 (US); Berg, Ryan, Hixson, TN Tennessee 37343 (US); Johnson, Eli Alexander, Ooletewah, TN Tennessee 37363 (US)
(74) Representative: Müller, Enno

(56) References cited:
- EP-A2- 2 746 784
- US-A1- 2006 186 872
- US-A1- 2014 184 425
- US-B1- 6 170 607

## Description

### FIELD OF THE DISCLOSURE

The present disclosure generally relates to a system and method used to detect voltage by an electric field detector on equipment.

### BACKGROUND

Reliably detecting high voltage on distribution and transmission voltage power lines around equipment is critical to the jobs performed by the operators of such equipment. These jobs are performed more quickly and safely when the voltage detection is also convenient and easy to use. As state of the art, it is to refer to US 2014/184425 A1, EP 2746784 A2, US 6170607 B1 and US 2006/186872 A1. The state of the art describes the link between an electric field detector and a central unit which however does not give the best possibilities for all situations.

### SUMMARY

According to the invention a system as defined in independent claim 1 and a method as defined in independent claim 13 are provided. Therein a plurality of electric field detectors for detecting voltage is provided on an equipment. The equipment includes a component which is configured to come into direct contact with, or come into proximity of, a conductor of electricity, and a control system which is in operative communication with the component. An electric field detector is provided on the equipment. The detector includes field detection circuitry configured to detect a voltage in an electric field in the environment which meets or exceeds a voltage threshold. When an overvoltage is detected by the electric field detector, the control system of the equipment is configured to act by performing one of 1) activating a warning module on the equipment and 2) causing the component of the equipment to act.

This Summary is provided merely for purposes of summarizing some example embodiments so as to provide a basic understanding of some aspects of the disclosure. Accordingly, it will be appreciated that the above described example embodiments are merely examples and should not be construed to narrow the scope of the disclosure which is defined by the appended claims.

Other embodiments, aspects, and advantages of various disclosed embodiments will become apparent from the following detailed description taken in conjunction with the accompanying drawings, which illustrate, by way of example, the principles of the described embodiments.

### BRIEF DESCRIPTION OF THE DRAWINGS

The organization and manner of the structure and operation of the disclosed embodiments, together with further objects and advantages thereof, may best be understood by reference to the following description, taken in connection with the accompanying drawings, which are not necessarily drawn to scale, wherein like reference numerals identify like elements in which:

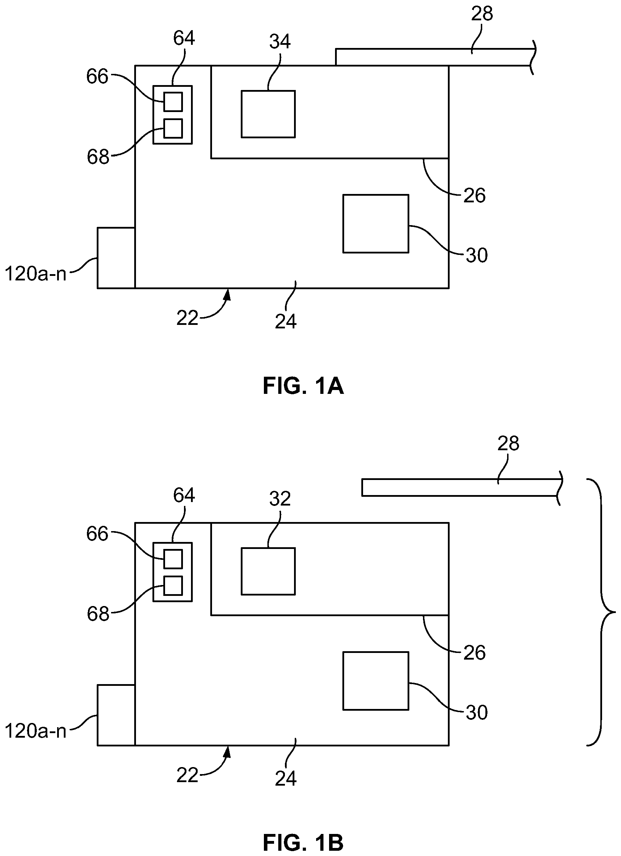

FIGS. 1A and 1B are schematic view of a piece of equipment and a conductor of electricity;
FIG. 2 is a block diagram of a control system of the piece of equipment;
FIG. 3 is a block diagram of a control apparatus of an electric field detector of the piece of equipment;
FIGS. 4-6 are flowcharts of example logic of the control apparatus;
FIGS. 7 and 8 are flowcharts of example logic of the control system;
FIGS. 9 and 10 are block diagrams of communication apparatus;
FIG. 11 is a perspective view of a housing for the electric field detector on the piece of equipment;
FIGS. 12-14 are side elevation views of the housing for the electric field detector on the piece of equipment;
FIG. 15 is a perspective view of a piece of equipment;
FIG. 16 is a side elevation view of another piece of equipment;
FIG. 17 is a side elevation view of a further piece of equipment; and
FIG. 18 is a perspective view of yet another piece of equipment.

### DETAILED DESCRIPTION OF THE ILLUSTRATED EMBODIMENTS

While the disclosure may be susceptible to embodiment in different forms, there is shown in the drawings, and herein will be described in detail, a specific embodiment with the understanding that the present disclosure is to be considered an exemplification of the principles of the disclosure, and is not intended to limit the disclosure to that as illustrated and described herein. Therefore, unless otherwise noted, features disclosed herein may be combined together to form additional combinations that were not otherwise shown for purposes of brevity. It will be further appreciated that in some embodiments, one or more elements illustrated by way of example in a drawing(s) may be eliminated and/or substituted with alternative elements within the scope of the disclosure.

In an embodiment, the present disclosure relates to voltage detection by an electric field detector 120a-n provided on a piece of equipment 22, and more particularly relates to detecting the presence of voltage that meets or exceeds one or more voltage thresholds (herein defined as an "overvoltage") in a vicinity around the equipment 22. In an embodiment, the present disclosure relates to voltage detection by an electric field detector 120a-n provided on a piece of equipment 22, and more particularly relates to detecting the presence of voltage that meets or exceeds a voltage threshold (herein defined as an "overvoltage") in a vicinity around the equipment 22. In response to the detection of the overvoltage, action is taken.

In an embodiment, the electric field detector 120a-n on the equipment 22 is configured to provide a warning, for example, a visual and/or audio warnings, to operators of the presence of the overvoltage. In an embodiment, the equipment 22 is configured to receive a warning notification from the electric field detector 120a-n and provide a warning, for example, a visual and/or audio warnings, of the presence of the overvoltage to an operator(s) of the equipment 22. In some embodiments, the equipment 22 is configured to receive a warning notification from the electric field detector 120a-n and in response, act. In some embodiments, the operator receives a warning and in response, acts. In an embodiment, multiple electric field detectors 120a-n are provided on the equipment 22. As used herein, the term "operator" or "operators" means a person or persons proximate to, or within, the equipment 22. In an embodiment, the voltage threshold is 236 Volts or greater, e.g., at 50Hz/60Hz. In some embodiments, the electric field detectors 120a-n detect alternating current (AC) voltage. In an embodiment, at least one or more of the electric field detectors 120a-n is placed in clear view of the operators working in or around the equipment 22.

In an embodiment, the equipment 22 includes a body 24 which has components 26 that come into direct contact with a conductor 28 of electricity or come into proximity of a conductor 28 of electricity. The equipment 22 has a control system 30 which is in operative communication with the components 26 and configured to control operation of the components 26. In an embodiment, the components 26 includes a motor 32 which activates other components 26 of the equipment 22 to cause the equipment 22 to perform a function. The motor 32 may, for example, include an electric motor, internal combustion engine, hydraulic motor, some combination thereof, or the like that is suitable to supply motive power to the equipment 22 and/or one or more moving components thereof. In an embodiment, the equipment 22 has wheels. In an embodiment, the equipment 22 is mounted on the ground.

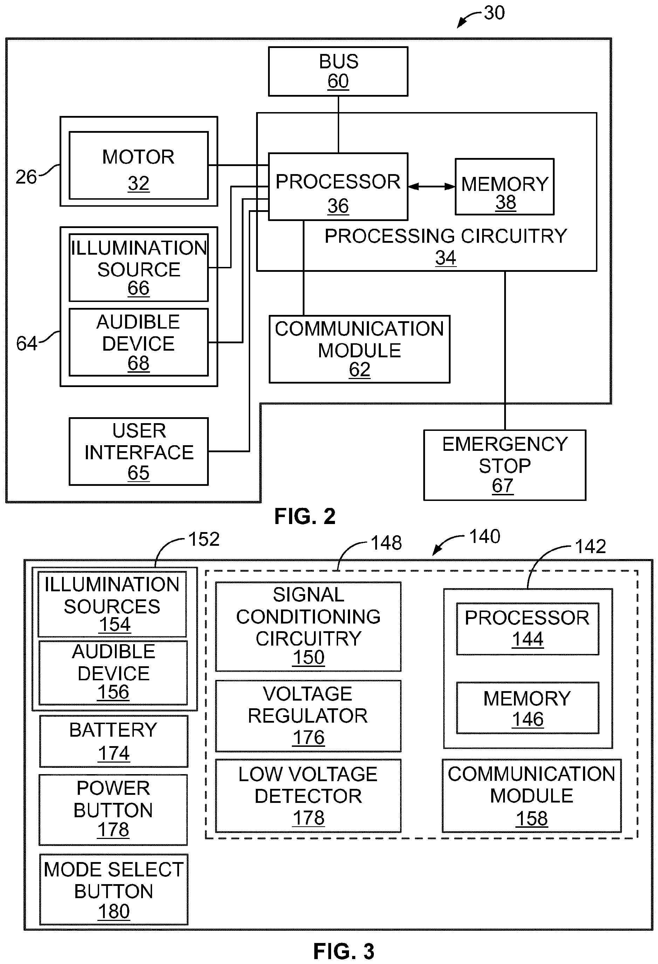

Attention is invited to FIG. 2 which illustrates a block diagram of a control system 30 of the equipment 22 in accordance with some example embodiments. It will be appreciated that the components, devices or elements illustrated in and described with respect to FIG. 2 below may not be mandatory and thus some may be omitted in certain embodiments. Additionally, some embodiments may include further or different components, devices or elements beyond those illustrated in and described with respect to FIG. 2.

In an embodiment, the control system 30 of the equipment 22 includes processing circuitry 34 that is configurable to perform actions in accordance with one or more example embodiments disclosed herein. The processing circuitry 34 may be configured to perform data processing, application execution and/or other processing and management services according to one or more example embodiments.

The processing circuitry 34 includes a processor 36 and, in some embodiments, may further include memory 38. In this regard, the processing circuitry 34 may be configured to perform and/or control performance of the components 26 in accordance with various example embodiments. It will be appreciated that the components, devices or elements illustrated in and described with respect to FIG. 2 may not be mandatory and thus some may be omitted in certain embodiments. Additionally, some embodiments may include further or different components, devices or elements beyond those illustrated in and described with respect to FIG. 2.

In some embodiments, the control system 30 or a portion(s) or component(s) thereof, such as the processing circuitry 34, may include one or more chipsets and/or other components that may be provided by integrated circuits.

The processor 36 may be embodied in a variety of forms. For example, the processor 36 may be embodied as various hardware-based processing means such as a microprocessor, a coprocessor, a controller or various other computing or processing devices including integrated circuits such as, for example, an ASIC (application specific integrated circuit), an FPGA (field programmable gate array), some combination thereof, or the like. Although illustrated as a single processor, it will be appreciated that the processor 36 may comprise a plurality of processors. The plurality of processors may be in operative communication with each other and may be collectively configured to perform one or more functionalities of the control system 30 as described herein. For example, in some embodiments in which the processor 36 comprises a plurality of processors, the plurality of processors may comprise one or more on-board controllers, such as may be implemented on the activator of some embodiments. In some example embodiments, the processor 36 may be configured to execute instructions that may be stored in the memory 38 or that may be otherwise accessible to the processor 36. Depending on the form of instructions that may be stored in the memory 38 or otherwise accessed by the processor 36, such execution of instructions may, for example, include execution of compiled executable code, translation or interpretation of stored program instructions, some combination thereof, or other method through which the processor 36 may read and execute computer program instructions. As such, whether configured by hardware or by a combination of hardware and software, the processor 36 is capable of performing operations according to various embodiments while configured accordingly.

In some example embodiments, the memory 38 may include one or more memory devices. Memory 38 may include fixed and/or removable memory devices. In some embodiments, the memory 38 may provide a non-transitory computer-readable storage medium that may store computer program instructions that may be executed by the processor 36. In this regard, the memory 38 may be configured to store information, data, applications, instructions and/or the like for enabling the control system 30 to carry out various functions in accordance with one or more example embodiments.

Each electric field detector 120a-n includes a control apparatus 140. Attention is invited to FIG. 3 which illustrates a block diagram of a control apparatus 140 that may be implemented on each electric field detector 120a-n in accordance with some example embodiments. It will be appreciated that the components, devices or elements illustrated in and described with respect to FIG. 3 below may not be mandatory and thus some may be omitted in certain embodiments. Additionally, some embodiments may include further or different components, devices or elements beyond those illustrated in and described with respect to FIG. 3.

The control apparatus 140 of each electric field detector 120a-n includes field detection circuitry 142 which is configured to detect voltage in the electric field in the area around the electric field detector 120a-n and to determine whether the detected voltage meets or exceeds the voltage threshold, and in response to the detection by the field detection circuitry 142 of an overvoltage, is configurable to perform actions in accordance with one or more example embodiments disclosed herein. An example field detection circuitry 142 is manufactured by HD ELECTRIC COMPANY TM, for example, as used in the WATCHMAN TM work area voltage detector, part number WM-01.

The field detection circuitry 142 may include a processor 144 and, in some embodiments, such as that illustrated in FIG. 3 may further include memory 146. The field detection circuitry 142 may be configured to perform data processing, application execution and/or other processing and management services according to one or more example embodiments.

The processor 144 may be embodied in a variety of forms. For example, the processor 144 may be embodied as various hardware-based processing means such as a microprocessor, a coprocessor, a controller or various other computing or processing devices including integrated circuits such as, for example, an ASIC (application specific integrated circuit), an FPGA (field programmable gate array), some combination thereof, or the like. Although illustrated as a single processor, it will be appreciated that the processor 144 may comprise a plurality of processors. The plurality of processors may be in operative communication with each other and may be collectively configured to perform one or more functionalities of the control apparatus 140 as described herein. In some example embodiments, the processor 144 may be configured to execute instructions that may be stored in the memory 146 or that may be otherwise accessible to the processor 144. Depending on the form of instructions that may be stored in the memory 146 or otherwise accessed by the processor 144, such execution of instructions may, for example, include execution of compiled executable code, translation or interpretation of stored program instructions, some combination thereof, or other method through which the processor 144 may read and execute computer program instructions. As such, whether configured by hardware or by a combination of hardware and software, the processor 144 is capable of performing operations according to various embodiments while configured accordingly.

The memory 146 can include one or more of a program memory, a cache, random access memory (RAM), a read only memory (ROM), a flash memory, a hard drive, etc., and/or other types of memory. In some example embodiments, the memory 146 may include one or more memory devices. Memory 146 may include fixed and/or removable memory devices. In some embodiments, the memory 146 may provide a non-transitory computer-readable storage medium that may store computer program instructions that may be executed by the processor 144. In some embodiments, the memory 146 may be configured to store information, data, applications, instructions (e.g., compiled executable program instructions, uncompiled program code, some combination thereof, or the like) and/or the like for enabling the control apparatus 140 to carry out various functions in accordance with one or more example embodiments. In some embodiments, the memory 146 may be in operative communication with the processor 144 via one or more buses for passing information among components of the control apparatus 140.

In some embodiments, some of the control apparatus 140 can reside on a printed circuit board assembly (PCBA) 148, or other type of electrical component assembly, e.g., a 3D printer process assembly. It will be appreciated that where PCBA 148 is described, it is described by way of non-limiting example, such that alternative assemblies on which circuitry and/or other electronic components may be embodied may be substituted for PCBA 148 within the scope of the disclosure, including but not limited to variously configured point-to-point constructed circuits, application-specific integrated circuit (ASIC), field programmable gate array (FPGA), etc. In some embodiments, the field detection circuitry 142 is located on the PCBA 148. Additional or fewer components may be included on the PCBA 148 depending on an implementation.

Signal conditioning circuitry 150 can turn signals into digital signals before being received by the field detection circuitry 142. Additionally, or alternatively, the control apparatus 140 may include an onboard analog-to-digital converter and/or other circuitry that may be configured to convert analog signals into digital signals, e.g., for processing.

In some embodiments, the control apparatus 140 or a portion(s) or component(s) thereof, such as the field detection circuitry 142, may include one or more chipsets and/or other components that may be provided by integrated circuits.

In some embodiments, the control apparatus 140 includes a warning module 152 in operative communication with the processor 144, and which includes one or more illumination sources 154 (to provide a visual warning to the operator) and/or one or more audible devices 156 (to provide an audio warning to the operator). Non-limiting examples of an illumination source 154 includes, but is not limited to, light emitting diodes (LEDs), incandescent bulbs, gas-based lamps, etc. Non-limiting examples of an audible device 156 includes, but is not limited to, a speaker and/or a horn. The warning module 152 includes the electrical components for energizing the one or more illumination sources 154 and/or the one or more audible devices 156. The field detection circuitry 142 is configured to perform and/or control performance of the warning module 152, such as illuminating the one or more illumination sources 154 and/or activating the one or more audible devices 156 in accordance with various example embodiments. In some embodiments, the memory 146 may be in operative communication with one or more of the processor 144 and the warning module 152 via one or more buses for passing information among components of the control apparatus 140.

In some embodiments, the control apparatus 140 includes a communication module 158. The communication module 158 may be configured to enable communication between the control apparatus 140 and another electric field detector 120a-n and/or the equipment 22 (e.g., with control system 30 of equipment 22) directly and/or via one or more computer networks. In this regard, the communication module 158 may include one or more interface mechanisms for enabling communication with other devices and/or networks. As such, the communication module 158 may include, for example, an antenna (or multiple antennas), a transceiver(s), other supporting hardware and/or software for enabling wireless (for example, via a wireless local area network) and/or wireline communications (for example., via a communication bus, such as a controller area network (CAN) bus, or other wireline communication bus) with another device or network. Examples of communication technologies that may be supported by various embodiments of the communication module 158 are further described herein below.

In an embodiment, the communication module 158 is configured to support wireless communication among the electric field detectors 120a-n. For wireless communications, the communication module 158 may include a transceiver, for example. In an embodiment, the electric field detectors 120a-n may communicate via an ad hoc (e.g., mesh) network that may be formed among electric field detectors 120a-n within range of each other, e.g., as established by the communication module 158. An example chip that may be provided and/or that may be integrated into the communication module 158 to enable communication over a radio frequency mesh network is provided by a Synapse Wireless, Inc. integrated circuit model number SM220UF1. However, it will be appreciated that other chips and controllers may be used within the scope of the disclosure.

Some non-limiting example of wireless communication technologies that may be used to facilitate formation of an ad hoc network, structured network, and/or direct wireless communication (e.g., peer-to-peer, or P2P) links between two or more electric field detectors 120a-n and which may be supported by the communication module 158 of various embodiments include one or more of an Institute of Electrical and Electronics Engineers (IEEE) 802.15 or other wireless personal area networking technology (e.g., ZigBee TM, BLUETOOTH TM, and/or the like), near field communication (NFC), IEEE 802.11 or other wireless local area networking communication technology (e.g., Wi-Fi), Wi-Fi Direct, Z-wave, WirelessUSB, WirelessHD, Wireless HART, ultra-wide band (UWB), Wireless Regional Area Network (WRAN), ISA2120a, Radio Frequency Identification (RFID), Infrared (IR), ISM Band, IEEE 1802.15.4, ANT+, 6LoWPAN, Ultra-Wideband, satellite networks, cellular networks, etc. However, it will be appreciated that communication between two or more electric field detectors 120a-n may be provided by any wireless communication technology that may be used to form an ad hoc or structured wireless local area network (LAN), personal area network (PAN), direct (e.g., P2P) communication link or the like within the scope of the disclosure.

In an embodiment, the electric field detectors 120a-n communicate with each other (e.g., to forward warning notifications) by a wired connection, such as may be provided by a communication bus 60 that may be implemented on the equipment 22 of some embodiments. For example, in some embodiments described further herein, the electric field detectors 120a-n may communicate with each other via a controller area network (CAN) bus that may be implemented on the equipment 22 of some embodiments. In various embodiments, the wired connection may be implemented through universal serial bus (USB), FireWire, Thunderbolt, Lightning, serial communications ports/connectors (e.g., D-subminiature serial connection), parallel communications ports/connectors, Ethernet (RJ-45 connector), and/or other wired communication types that may be used to physically interface the electric field detectors 120a-n.

The communication module 158 of some embodiments is configured to send a warning notification to another electric field detector 120a-n in the system and/or receive a warning notification from another electric field detector 120a-n in the system. For example, the communication module 158 of some embodiments is configured to receive the warning notification from one or more of the other electric field detectors 120a-n in the system, and is configured to communicate an indication of the warning notification to its field detection circuitry 142. In an embodiment, the communication module 158 is configured to process or modify the received warning notification and forward the processed or received warning notification to its field detection circuitry 142.

In some embodiments, the electric field detectors 120a-n can act as repeaters to repeat the warning notifications of the overvoltage to other electric field detectors 120a-n within range even though the electric field detectors 120a-n are not within range of the electric field detector 120a-n originating the warning notification. In some embodiments, the electric field detectors 120a-n may connect and communicate with each other via a structured wireless local area network (LAN) and/or personal area network (PAN) network with an access point or master unit. A master unit of the structured network, can, for example, be one of the electric field detectors, e.g. 120a, designated as a master. As another example, in some embodiments, the control system 30 and/or other module or device that may be implemented on the equipment 22 may provide a structured wireless network access point to which one or more electric field detectors 120 may connect.

When implemented on each electric field detector 120a-n, the control apparatus 140 enables each electric field detector 120a-n to detect the voltage in the electric field in the area around the electric field detector 120a-n and determine whether the detected voltage meets or exceeds the voltage threshold, to energize the one or more illumination sources 154 (if provided) and/or the one or more audible devices 156 (if provided), to provide the warning to the operators, to communicate with the other electric field detectors 120a-n in the system, and to communicate with the control system 30 of the equipment 22, in accordance with one or more example embodiments.

The electric field detectors 120a-n can be provided in a variety of places on the equipment 22. For example, in an embodiment, the electric field detectors 120a-n can be positioned at a front of the equipment 22, at a rear of the equipment 22, on the sides of the equipment 22, in high, medium and/or low positions in and around the equipment 22 relative to the ground, and/or in other spatial arrangements that disperse the electric field detectors 120a-n to provide voltage detection coverage throughout the equipment 22. In this way, the electric field detectors 120a-n can detect voltage up above the equipment 22, down between the equipment 22 and the ground, and/or on all sides of the equipment 22, as determined by positioning the electric field detectors 120a-n. In some embodiments, the electric field detectors 120a-n can be placed at determined access points and/or at points of service on the equipment 22, including but not limited to engine access points, a hood covering the engine, power take offs, e.g., for connecting ancillary tools, and/or places for the operators to step onto or off of the equipment 22, etc. In some embodiments, electric field detectors 20a-n are placed at the corners of the equipment 22, e.g., to provide visibility of warning signals from the electric field detectors 120a-n to the operators, as described in more detail below. In addition, in some embodiments, an electric field detector can be positioned in a cab of the equipment 22 where the operator is located for operating the equipment 22 and/or in an operating station of the equipment 22 where the operator is located for operating the equipment 22. Additional and alternative positions to those described and/or shown herein can be used.

In some embodiments, e.g., if the equipment 22 is grounded, one electric field detector 120d is placed under the equipment 22, or integrated into an assembly of the equipment 22, to measure a voltage potential between ground and equipment 22. By pointing the electric field detector 120d down toward the ground, the electric field detector 120d can detect whether there is an electric field between the equipment 22 and the ground, indicating that equipment 22 has become ungrounded. Other electric field detectors 120a-c and e-n may not be needed in this implementation, but others can be used.

Placement of the electric field detectors 120a-n in different locations around the equipment 22 can serve different purposes. For example, in an embodiment, the electric field detectors 120a-n can be positioned at a front of the equipment 22, at a rear of the equipment 22, on the sides of the equipment 22, in high, medium and/or low positions in and around the equipment 22 relative to the ground, and/or in other spatial arrangements that disperse the electric field detectors 120a-n to provide voltage detection coverage throughout the equipment 22 and the ability of operators to view/hear one or more electric field detectors 120a-n. For example, in an embodiment where the electric field detectors 120a-n are positioned in the cab of the equipment 22 where the operator is located for operating the equipment 22 and/or in the operating station of the equipment 22 where the operator is located for operating the equipment 22, and the electric field detectors 120a-n are positioned around the equipment 22, the electric field detector(s) positioned in the cab and/or in the operating station provides the operator with the ability to view/hear the electric field detector(s) positioned in the cab and/or in the operating station. In some embodiments, the electric field detectors 120b and 120c can be positioned near the components 26 to detect if the conductor 28 is ungrounded, e.g., became live with respect to the equipment 22. Additionally, or alternatively, the electric field detector 120a-n positioned on a front and side of the equipment 22, respectively, can detect voltage from downed lines on the front/side of the equipment 22.

A detection range of the electric field detectors 120a-n can overlap each other for full coverage of the area, or a partial area can be covered by the range of the electric field detectors 120a-n, based on an implementation. In some embodiments, a range of the electric field detectors 120a-n is about ten feet, depending on strength of the voltage in the vicinity. However, it will be appreciated that the range of an electric field detector 120a-n can vary depending on a variety of factors, such as, for example, the particular form of field detection circuitry 142 used and the threshold set for detecting the overvoltage condition. In some embodiments, at least the entirety of the equipment 22 interacted with is within a detection range of the group of electric field detectors 120a-n.

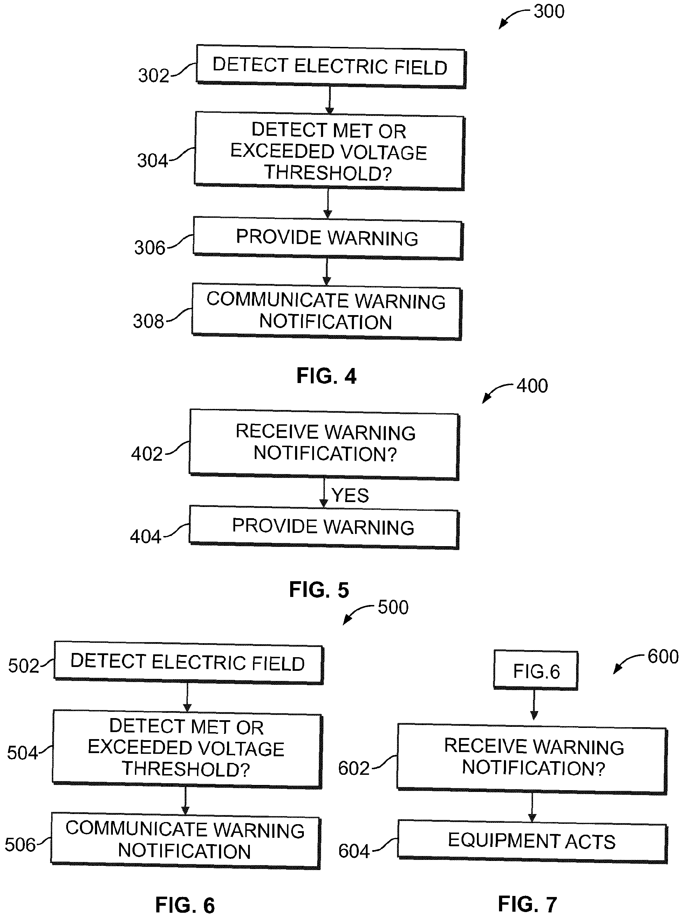

FIG. 4 is a flowchart of an example logic 300 of an electric field detector 120a-n. For convenience in description relating to the flowchart of FIG. 4, electric field detector 120a is described, with the understanding that the other electric field detectors 120b-n operate in the same manner. The electric field detector 120a detects the voltage in the electric field in the area around the electric field detector 120a (302). The electric field detector 120a waits for the voltage threshold in the electric field being detected to be met and/or exceeded and determines that there is an overvoltage in the electric field (304). In response to the determination that there is an overvoltage in the electric field, the electric field detector 120a activates its warning module 152 (306). In response to the determination that there is an overvoltage in the electric field, the electric field detector 120a communicates a warning notification to the other electric field detectors 120b-n in the system (308).

FIG. 5 is a flowchart of an example logic 400 of a second electric field detector 120a-n of some embodiments. For convenience in description relating to the flowchart of FIG. 5, electric field detector 120b is described, with the understanding that the other electric field detectors 120a, 20c-n operate in the same manner. In response to receipt of the warning notification (402), the second electric field detector 120b activates its warning module 152 (404).

In addition to or alternatively to communication between electric field detectors 120an, in some embodiments, one or more electric field detectors 120a-n may be configured to communicate with the control system 30 of the equipment 22 to cause the equipment 22 to act in response to the detection of the overvoltage.

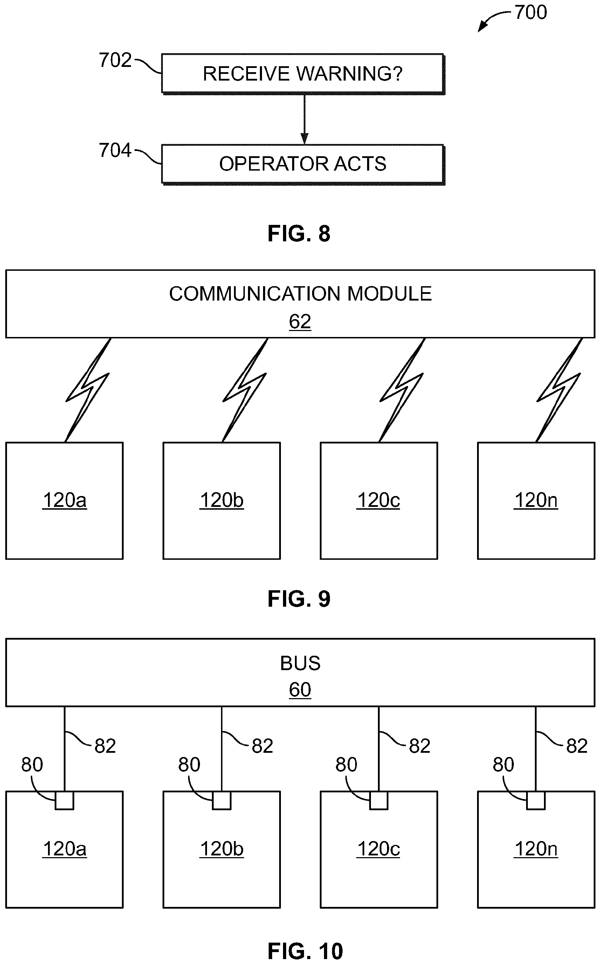

In this regard, the control system 30 of some embodiments includes a communication module 62, see FIGS. 2 and 8, configured to facilitate communication with one or more electric field detectors 120a-n directly and/or via one or more computer networks. In this regard, the communication module 62 may include one or more interface mechanisms for enabling communication with other devices and/or networks. As such, the communication module 62 may include, for example, an antenna (or multiple antennas), a transceiver(s), other supporting hardware and/or software for enabling wireless (for example, via a wireless local area network) and/or wireline communications (for example, via a controller area network (CAN) bus or other wireline communication bus) with another device or network. Examples of various communication technologies that may be supported by various embodiments of the communication module 62 are described herein with respect to various embodiments. However, it will be appreciated that the communication module 62 may be configured to support communication via any mode or technology by which the communication module 158 may communicate in accordance with various embodiments.

In some embodiments, communication between the electric field detectors 120a-n and the equipment 22 and which may be supported by the communication modules 158, 62 of various embodiments may be configured to communicate with each other wirelessly. For wireless communications, the communication module 62 may include a transceiver, for example. In an embodiment, the communication module 158 of the electric field detectors 120a-n and the communication module 62 of the equipment 22 may communicate via an ad hoc (e.g., mesh) network. An example chip that may be provided and/or that may be integrated into the communication module 158 and the communication module 62 to enable communication over a radio frequency mesh network is provided by a Synapse Wireless, Inc. integrated circuit model number SM220UF1. However, it will be appreciated that other chips and controllers may be used within the scope of the disclosure.

Some non-limiting example of wireless communication technologies that may be used to facilitate formation of an ad hoc network, structured network, and/or direct wireless communication (e.g., peer-to-peer, or P2P) links between the electric field detectors 120a-n and the equipment 22 of various embodiments include one or more of an Institute of Electrical and Electronics Engineers (IEEE) 802.15 or other wireless personal area networking technology (e.g., ZigBee TM, BLUETOOTH TM, and/or the like), near field communication (NFC), IEEE 802.11 or other wireless local area networking communication technology (e.g., Wi-Fi), Wi-Fi Direct, Z-wave, WirelessUSB, WirelessHD, Wireless HART, ultra-wide band (UWB), Wireless Regional Area Network (WRAN), ISA2120a, Radio Frequency Identification (RFID), Infrared (IR), ISM Band, IEEE 1802.15.4, ANT+, 6LoWPAN, Ultra-Wideband, satellite networks, cellular networks, etc. However, it will be appreciated that communication between the electric field detectors 120a-n and the equipment 22 may be provided by any wireless communication technology that may be used to form an ad hoc or structured wireless local area network (LAN), personal area network (PAN), direct (e.g., P2P) communication link or the like within the scope of the disclosure.

In some embodiments, communication between the electric field detectors 120a-n and the control system 30 of the equipment 22 may by operably via a wired connection. In an embodiment, the control system 30 of the equipment 22 includes the communication bus 60, see FIGS. 2 and 10. The communication bus 60 may, for example, be implemented as a controller area network (CAN) bus, but it will be appreciated that other bus types and protocols may be used to implement the communication bus 60. The electric field detector 120a-n, may in turn, include a bus connection 80, such as may be provided by the communication module 158 of various embodiments. The bus connection 80 may be physically coupled to the communication bus 60 via cable 82 so as to communicatively couple the electric field detector 120a-n to the equipment 22. The cable 82 may be implemented via any physical connection that may be used to communicatively couple a device to a bus, such as communication bus 60. Connections include any type of physical or electronic connection/intercommunication between components that supports appropriate interoperability of components. In various embodiments, the wired connection may be implemented through universal serial bus (USB), FireWire, Thunderbolt, Lightning, serial communications ports/connectors (e.g., D-subminiature serial connection), parallel communications ports/connectors, Ethernet (RJ-45 connector), and/or other wired communication types that may be used to physically interface the electric field detector 120a-n with the equipment 22.

The communication module 62 of the equipment 22 of various embodiments is configured to receive the warning notification from one or more of the electric field detectors 120a-n in the system, and is configured to communicate an indication of the warning notification to the processing circuitry 34. In an embodiment, the communication module 62 is configured to process or modify the received warning notification and forward the processed or received warning notification to the processing circuitry 34. In an embodiment, in response to the receipt of the indication of the warning notification, the processing circuitry 34 of the equipment 22 propagates a warning notification to the electric field detectors 120a-n in the system.

In some embodiments, the equipment 22 includes a warning module 64 which is in operative communication with the processor 36 and the communication module 62 and which includes one or more illumination sources 66 (to provide a visual warning to the operator) and/or one or more audible devices 68 (to provide an audio warning to the operator). The warning module 64 includes the electrical components for energizing the one or more illumination sources 66 and/or the one or more audible devices 68. In some embodiments, the warning module 64 is provided in a cab of the equipment 22 such that one or more illumination sources 66 flashes and/or the one or more audible devices 68 provide an audible indication in the cab of the equipment 22. In some embodiments, the one or more illumination sources 66 are provided by the headlamps of the equipment 22. Non-limiting examples of an illumination source 66 includes, but is not limited to, light emitting diodes (LEDs), incandescent bulbs, gas-based lamps, etc. Non-limiting examples of an audible device 68 includes, but is not limited to, a speaker and/or a horn. In some embodiments, the one or more audible devices 68 are provided in the cab and the one or more illumination sources 66 are provided by the headlamps of the equipment 22. The processing circuitry 34 is configured to perform and/or control performance of the warning module 64 such as illuminating the one or more illumination sources 66 and/or activating the one or more audible devices 68 in accordance with various example embodiments.

FIG. 6 is a flowchart of an example logic 500 of an electric field detector 120a-n of some embodiments. The electric field detector 120a-n detects the voltage in the electric field in the area around the electric field detector 120a-n (502). The electric field detector 120a-n waits for the voltage threshold in the electric field to be met and/or exceeded and determines that there is an overvoltage (504). In response to the determination that there is an overvoltage in the electric field, the electric field detector 120a-n communicates a warning notification to the control system 30 of the equipment 22 (508).

In some embodiments, the equipment 22 includes a user interface 65 which is in operative communication with the processor 36 and which receives the warning notification and indicates a warning to the operator. In some embodiments, the user interface 65 is positioned in a cab of the equipment 22 and/or at any location on the equipment 22. In some embodiments, the user interface 65 is provided on an associated computing devices, including but not limited to, smart phones, tablets, laptops, personal computers (PC). The user interface 65 may take the form of a display. The user interface 65 may display the warning, such as by display text on screen, a designated color (e.g., red), and/or other indicia, etc.

FIG. 7 is a flowchart of an example logic 600 of the equipment 22 of some embodiments. In some embodiments, in response to the receipt of the warning notification from the electric field detector 120a-n from the flow chart of FIG. 6, the control system 30 of the equipment 22 acts. In some embodiments, the control system 30 of the equipment 22 acts by performing one or more of 1) activating its warning module 64, 2) stopping operation of the equipment 22 by shutting down operation of the components 26, 3) causing the components 26 of the equipment 22 to act in a particular manner (e.g., by deactivating, limiting movement, or otherwise limiting activity of one or more components 26), 4) sending a warning notification to the electric field detectors 120a-n, and 5) activating the warning on the user interface 65. In an embodiment where the equipment 22 acts by sending a warning notification to the electric field detectors 120a-n, in response, the electric field detectors 120a-n perform the actions of the flow chart of FIG. 5.

FIG. 8 is a flowchart of an example logic 700 of some embodiments. In some embodiments, in response to the receipt of the warning from the electric field detector 120a-n in the flow chart of FIG. 4 (306) or FIG. 5 (404), the operator of the equipment 22 acts. In some embodiments, the operator of the equipment 22 acts by performing one or more of 1) stopping operation of the equipment 22 by shutting down operation of the components 26, and 2) causing the components 26 of the equipment 22 to act in a particular manner (e.g., by deactivating, limiting movement, or otherwise limiting activity of one or more components 26). Such an action may be performed by an emergency stop button 67 located on the equipment 22 which is in communication with the processing circuity 34. In an embodiment, the emergency stop button 67 is located in the cab of the equipment 22. In an embodiment, the emergency stop button 67 is located at access points and/or at points of service on the equipment 22.

In an embodiment, if one electric field detector 120a detects overvoltage, then every electric field detector 120b-n indicates the same warning via the warning modules 244. In an embodiment, if one electric field detector 120a detects overvoltage, then every electric field detector 120b-n and the equipment 22 indicates the same warning via the warning modules 244, 64.

In an embodiment, if one electric field detector 120a detects overvoltage, then the electric field detector 120a indicates a warning, but the other electric field detector 120b-n indicate a different warning (e.g., different light color/pattern and/or audible tones/volumes/patterns, etc.) than the one indicated by the electric field detector 120a. In an embodiment, if one electric field detector 120a detects overvoltage, then the electric field detector 120a indicates a warning, but the other electric field detector 120b-n and the equipment 22 indicate a different warning (e.g., different light color/pattern and/or audible tones/volumes/patterns, etc.) than the one indicated by the electric field detector 120a.

In an embodiment, multiple electric field detectors 120a and 120c detect the overvoltage and provide a different warning (e.g., different light color/pattern and/or audible tones/volumes/patterns, etc.) than the electric field detectors 120b and 120d that do not detect the overvoltage, but receive the warning notification and/or repeat the warning. The type of warning can be based on both the received warning notification as well as the voltage detected by the particular electric field detector. In an embodiment, multiple electric field detectors 120a and 120c detect the overvoltage and provide a different warning (e.g., different light color/pattern and/or audible tones/volumes/patterns, etc.) than the equipment 22 and the electric field detectors 120b and 120d that do not detect the overvoltage, but receive the warning notification and/or repeat the warning. The type of warning can be based on both the received warning notification as well as the voltage detected by the particular electric field detector.

In an embodiment, the electric field detectors 120a-n are configured to detect multiple voltage thresholds and the warnings provided by the warning modules 244 indicate field strength of the detected voltage. In an embodiment, the electric field detectors 120a-n are configured to detect multiple voltage thresholds and the warnings provided by the warning modules 244, 64 indicate field strength of the detected voltage. For example, if a first voltage threshold is met, then the electric field detectors 120a-n and/or the equipment 22 provides a warning in a first way; if a second voltage threshold is met, then the electric field detectors 120a-n and/or the equipment 22 provide a warning in a second way which is different (e.g., different light color/pattern and/or audible tones/volumes/patterns, etc.) from the first way; etc. For example, the first way may use the one or more illumination sources 154 and/or 66 to flash at a first rate and/or the one or more audible devices 156 and/or 68 to beep at a first rate; and the second way may use the one or more illumination sources 154 and/or 66 to flash at a second rate which is different from the first rate and/or the one or more audible devices 156 and/or 68 to beep at a second rate which is different from the first rate; etc. As a more particular example, in some such embodiments, there may be a first voltage threshold and a second voltage threshold, with the second voltage threshold being higher than the first voltage threshold. A first electric field detector, for example electric field detector 120a, may detect a voltage exceeding the first voltage threshold, but not the second voltage threshold, and may provide a first warning (e.g., an orange light, a light pattern blinking at a first rate, and/or a first audible tones/volumes/patterns, etc.) while a second electric field detector, for example electric field detector 120b, may detect a voltage exceeding the second voltage threshold and may provide a second warning different than the first warning (e.g., a red light, a light pattern blinking at a second rate, and/or a second audible tones/volumes/patterns, etc.).

Voltage thresholds of the electric field detectors 120a-n can be assigned or dynamically chosen based on the current set of voltages observed in the system. In an embodiment, the operator uses the user interface 65 to assign voltage thresholds of the electric field detectors 120a-n for different applications in which the equipment 22 is being used. For example, the equipment 22 is being used for work on a transmission line (long haul lines, e.g., on towers which transmit higher voltage), in some embodiments, the operator might assign a higher voltage threshold versus if the equipment 22 is being used for work on distribution line (a shorter haul line to homes/neighborhoods, e.g., on poles which transmit lower voltage than the voltage transmitted on distribution lines) where the assigned voltage threshold may be lower.

In an embodiment, when one electric field detector, for example electric field detector 120a, detects one of the voltage thresholds, a warning notification is sent to the other electric field detectors 120b-n that do not detect the overvoltage, and all of the electric field detectors 120a-n provide the same warning. In an embodiment, when one electric field detector 120a detects one of the voltage thresholds, a warning notification is sent to the other electric field detectors 120b-n that do not detect the overvoltage, and electric field detector 120a provides a different warning than the warnings provided by the other electric field detectors 120b-n. In an embodiment, one electric field detector 120a detects one of the voltage thresholds and send a warning notification to the other electric field detectors 120b-n, and another one of the electric field detectors 120b detects the same or a different voltage threshold and sends a warning notification to the other electric field detectors 120a, c, d; wherein electric field detector 120a provides a different warning than electric field detector 120b, and the remaining electric field detectors 120c, d provide further different warnings.

In each embodiment, the different types of warnings can be indicated by the electric field detectors 120a-n using the warning module 152 to provide varying lights, sounds or a combination of lights and sounds, including but not limited to a strength of the light or sound (e.g., a luminous intensity of the light; a loudness, such as may be measured in decibels of the sound; or the like), different light colors, different number of lights illuminated, different audio warning (louder/softer, different tones), etc., that indicate strength of voltage detected.

In an embodiment, the field detection circuitry 142 of each electric field detector 120a-n is configured to control the warning modules 244 such that one or more illumination sources 154 provides constant illumination, varying illumination, and/or turn them on and off in a pattern, etc., to catch the attention of an operators. For example, the electric field detector 120a-n can provide a heartbeat type pattern to indicate that it is actively checking for electric fields having voltage meeting or exceeding the voltage threshold, and a spinning pattern can indicate an electric field and nearby energized conductor 28.

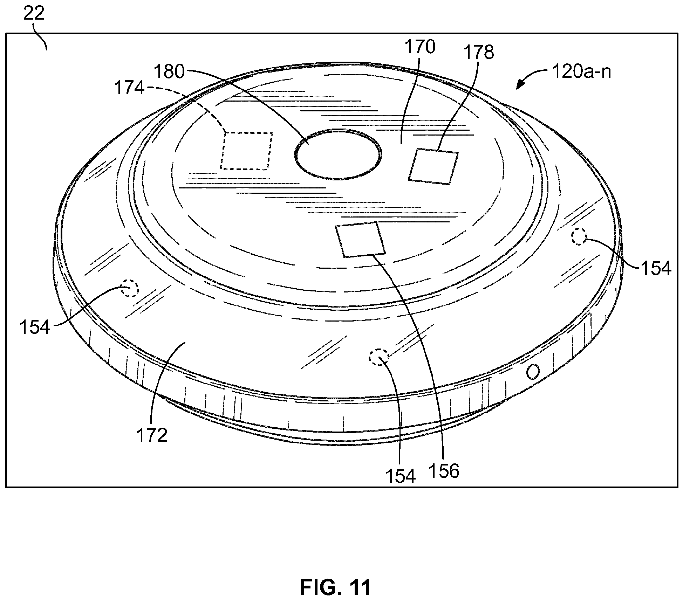

In some embodiments as shown in FIG. 11, one or more of, or all of, the electric field detectors 120a-n are formed as separate members and are mounted onto the equipment 22. In an embodiment, the one or more of the electric field detector 120a-n includes a housing 170 having a transparent or translucent cover 172, and one or more illumination sources 154 mounted within the housing 170 under the cover 172 to provide a visual warning to the operators that the electric field detector 120a-n has detected an overvoltage. The cover 172 protects and diffuses light from the one or more illumination sources 154. Additionally, or alternatively, one or more electric field detector 120a-n includes one or more audible devices 156 to provide an audio warning to the operators that the electric field detector 120a-n has detected an overvoltage. In an embodiment, the electric field detector 120a-n includes a battery 174 for powering the electric field detector 120a-n.

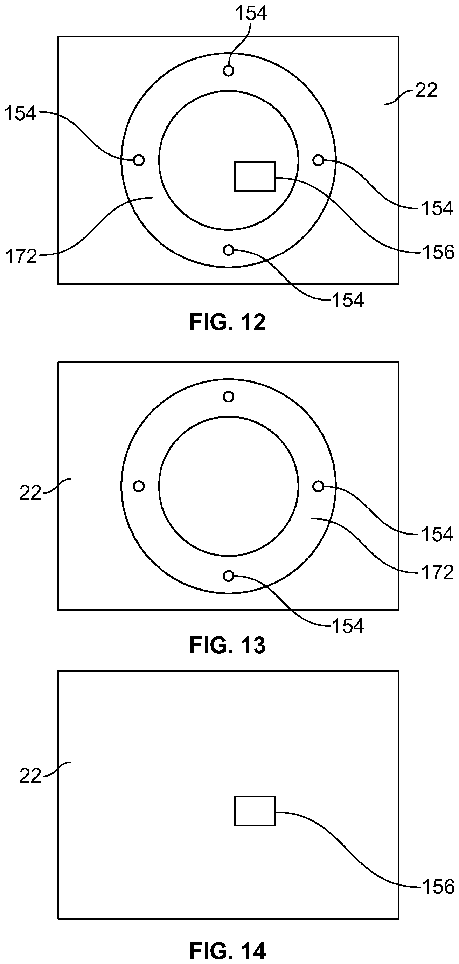

In some embodiments as shown in FIGS. 11-13, one or more of, or all of, the electric field detectors 120a-n are integrally formed with the equipment 22. In some such embodiments, the electric field detectors 120a-n may include the cover 172 affixed to the equipment 22 and the one or more illumination sources 154 and/or the one or more audible devices 156.

In an embodiment, the control apparatus 140 includes a voltage regulator 176, see FIG. 3, which supplies a proper voltage from the battery 174 to the other components of the control apparatus 140. In an embodiment, a low voltage detector 178, see FIG. 3, can monitor a battery charge level of the battery 174 so that the electric field detector 120a-n can notify the operators, e.g., by activating the warning module 152, in a way that varies from the warning of the overvoltage to indicate a low battery charge level. However, it will be appreciated that the electric field detector 120a-n may additionally or alternatively be powered by an electrical system of the equipment 22, and in some embodiments the battery 174 may be omitted. Depending on structural implementation and/or an operator selected deployment configuration, the electric field detectors 120a-n can be configured to be fixedly or removably be mounted on the equipment 22. In some embodiments, the electric field detectors 120a-n are configured to rest on the equipment 22. Additionally, or alternatively, the electric field detectors 120a-n can be removably fastened to the equipment 22 using straps and/or magnets and other types of fasteners. Additionally, or alternatively, the housing 170 of the electric field detector 120a-n may be fastened to the equipment 22 in a manner such that they are not readily removable, such as through riveting, welding, etc.

In an embodiment, the electric field detector 120a-n includes a power button 178. In an example embodiment as shown in FIG. 11, the power button 178 is on a top of the housing 170. In an embodiment, the power button 178 is on a bottom of the housing 170. The power button 178, if provided, can also be used to verify the battery charge level when held down. In an embodiment, the electric field detector 120a-n are activated/deactivated via a user control on the equipment 22 (the power button 178 may be eliminated). In an embodiment, the user control is provided by a button in the cab of the equipment 22 which is in operative communication with the electric field detector 120a-n to activate/deactivate the electric field detector 120a-n.

In some embodiments, the electric field detector 120a-n may include mode selection that can include independent mode select, coordinated mode select, or a selectable channel(s). The mode selection can be selected by a user depressing a mode select button 180 on the electric field detector 120a-n, or additionally or alternatively the mode selection can be selected via a user control panel of the equipment 22. In an example embodiment as shown in FIG. 11, the mode select button 180 is on a top of the housing 170. For example, the electric field detector 120a-n operating in independent mode may only provide a warning if that electric field detector, for example electric field detector 120a, itself, detects voltage, and may not communicate with other electric field detectors 120a-n within range or at least may not repeat warnings from other electric field detectors 120a-n within range. Coordinated mode may set the electric field detector 120a-n to repeat a warning from an electric field detector 120a-n within range that has detected overvoltage. Channel selection may be provided in addition to or in lieu of coordinated mode. In channel select, the electric field detector 120a-n may support communication via a plurality of selectable wireless channels, e.g., 1, 2, 3. For example, electric field detectors 120a-n within range of each other or that are connected to same network that are on channel 1 can display and/or sound warnings together. If one electric field detector 120a-n on channel 1 detects voltage, all electric field detectors on channel 1 can sound warnings, but electric field detectors 120a-n on channel 1 may not repeat any warning from an electric field detector 120a-n on channel 2 that detects overvoltage, such that an electric field detector, for example electric field detector 120a, on channel 2 in such embodiments may only display and/or sound a warning if it or another electric field detector, for example electric field detector 120b, on channel 2 detects overvoltage. The channels can be used to group electric field detectors 120a-n together in the equipment 22, in which all electric field detectors 120a-n of a first portion of the equipment 22 can coordinate separately from electric field detectors 120a-n in a second portion of the equipment 22, as determined by the separate channels.

In an embodiment, the control apparatus 140 includes an emergency stop circuit 182 which is automatically activated in response to detection of overvoltage by the electric field detector 120a-n. In some embodiments, in response to the receipt of the indication of the warning notification, the emergency stop circuit 182 is automatically activated and the motor 32 driving the components 26 is stopped or the motor 32 is shut down thereby stopping the components 26.

In some embodiments, in response to the receipt of the indication of the warning notification, the processing circuitry 34 of the equipment 22 causes the components 26 to act. As an example, in some embodiments, the processing circuitry 34 of the equipment 22 causes the motor 32 driving the components 26 to stop or causes the motor 32 to shut down thereby stopping the components 26. In some embodiments, when the emergency stop button 67 is activated, the motor 32 is stopped thereby stopping the components 26, or the motor 32 is shut down thereby stopping the components 26. In some embodiments, the engine of the cable puller 800 is shut down when the equipment 22 acts or when the operator activates the emergency stop button 67.

In some embodiments, the systems and methods describe electric field detectors 120an applied to equipment 22 including but not limited to distribution and transmission line stringing and tensioning equipment 22. The equipment 22 can include, but is not limited to, pullers, tensioners, puller-tensioner, and puller/tensioner/reconductorer, reel stands, reel trailers, bucket trucks, backhoes, cranes, digger derrick trucks, other types of construction equipment, non-construction equipment, other equipment used in the presence of high voltage lines, etc., whether for servicing the lines, working around the lines, tree trimming near the lines, etc. In an embodiment, the equipment 22, includes, but is not limited to, equipment 22 that is above ground, underground, overhead. In an embodiment, the equipment 22 has a cab in which the operator sits and the warning module 64 is located in the cab. The voltage may be generated by power lines, cable television lines, telecommunication lines, metal structures in the presence of storms, etc.

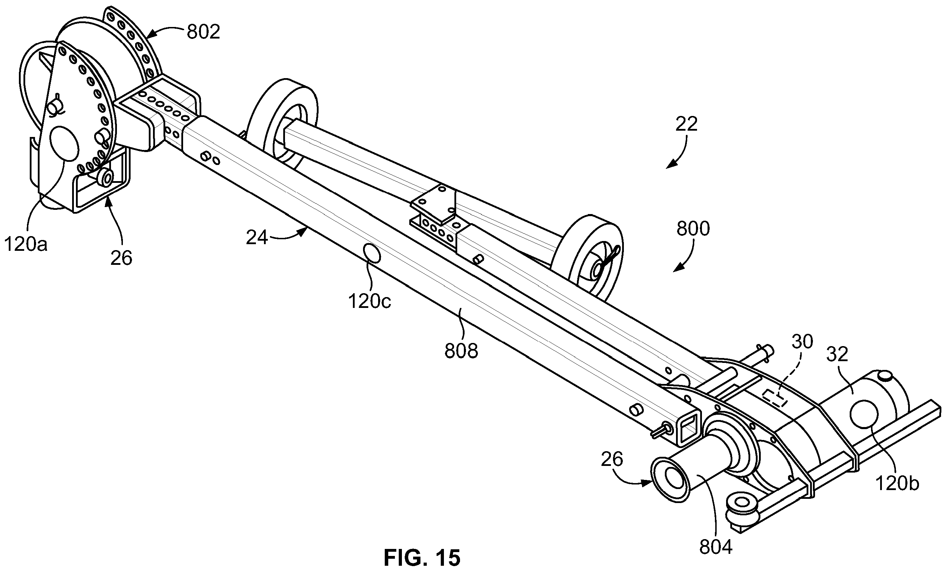

In an embodiment, as shown in FIG. 15, the equipment 22 is a cable puller 800 which pulls conductors 28 in the form a cable or wire, and the components 26 on the body 34 are a nose 802 of the cable puller 800 and a driven capstan 804 of the cable puller 800 which come into direct contact with the conductor 28. The capstan 804 is driven by motor 32 which is operatively connected to and controlled by the control system 30 of the equipment 22. As is known in the art, the nose 802 and the capstan 804 are connected by a boom 808. At a minimum, the nose 802 and the capstan 804 of the cable puller 800 form the components 26 of the equipment 22 which come into direct contact with the conductor 28. The electric field detectors 120a-n are placed at various locations on the cable puller 800 or are integrated into the cable puller 800. As an example, an electric field detector may be placed on either side of the nose 802, on sides of the boom 808, under the boom 808, on top of the boom 808, proximate to or on the capstan 804. Numerous other locations for positioning the electric field detectors 120a-n are within the scope of the disclosure and the positions shown in FIG. 15 are for example purposes only. As an example, in some embodiments, the processing circuitry 34 of the equipment 22 causes the motor 32 driving the capstan 804 to stop rotating the capstan 804 or causes the motor 32 to shut down thereby stopping rotation of the capstan 804; in some embodiments, this occurs automatically by the emergency stop circuit 182 in response to the detection of overvoltage. In some embodiments, when the emergency stop button 67 is activated by the operator, the motor 32 is stopped thereby stopping rotation of the capstan 804, or the motor 32 is shut down thereby stopping rotation of the capstan 804. In some embodiments, the engine of the cable puller 800 is shut down when the cable puller 800 acts or when the operator activates the emergency stop button 67.

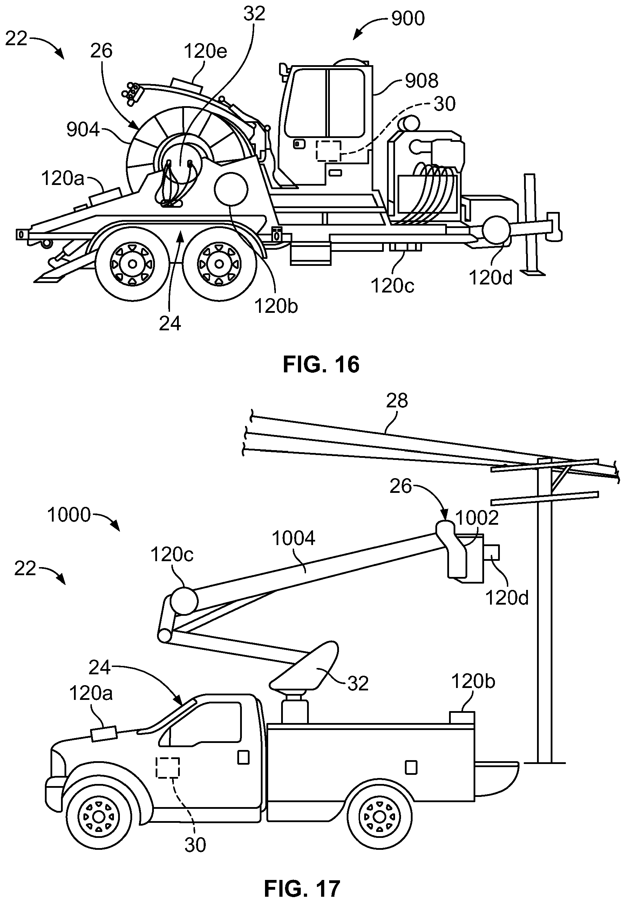

In an embodiment, as shown in FIG. 16, the equipment 22 is a puller/tensioner vehicle 900 which pulls conductors 28 in the form a cable or wire, and the components 26 on the body 34 is a driven cable reel 904, known as a bull wheel, of the puller/tensioner vehicle 900. The cable reel 904 is driven by a motor 32 which is operatively connected to and controlled by the control system 30 of the equipment 22. The electric field detectors 120a-n are placed at various locations on the puller/tensioner vehicle 900 or are integrated into the puller/tensioner vehicle 900. As an example, electric field detectors may be placed proximate to the cable reel 904 on either side thereof, by a cab 908 of the puller/tensioner vehicle 900, on top of the puller/tensioner vehicle 900, under the puller/tensioner vehicle 900. Numerous other locations for positioning the electric field detectors 120a-n are within the scope of the disclosure and the positions shown in FIG. 16 are for example purposes only. As an example, in some embodiments, the processing circuitry 34 of the equipment 22 causes the motor 32 driving the cable reel 904 to stop rotating the cable reel 904 or the motor 32 is shut down thereby stopping rotation of the cable reel 904; in some embodiments, this occurs automatically by the emergency stop circuit 182 in response to the detection of overvoltage. In some embodiments, when the emergency stop button 67 is activated by the operator, the motor 32 is stopped thereby stopping rotation of the cable reel 904, or the motor 32 is shut down thereby stopping rotation of the cable reel 904. In some embodiments, the engine of the puller/tensioner vehicle 900 is shut down when the puller/tensioner vehicle 900 acts or when the operator activates the emergency stop button 67.

In an embodiment, as shown in FIG. 17, the equipment 22 is a bucket truck 1000, and the components 26 on the body 34 are a bucket 1002 mounted on a driven boom 1004 that lifts the bucket 1002 into proximity to the conductor 28. The boom 1004 is driven by a motor 32 which is operated by the control system 30 of the bucket truck 1000. The electric field detectors 120a-n are placed at various locations on the bucket truck 1000 or are integrated into the bucket truck 1000. As an example, field detectors may be placed on the hood of the bucket truck 1000 and on the bed of the bucket truck 1000, on the boom 1004, on the bucket 1002. Numerous other locations for positioning the electric field detectors 120a-n are within the scope of the disclosure and the positions shown in FIG. 17 are for example purposes only. As an example, in some embodiments, the processing circuitry 34 of the equipment 22 causes the motor 32 to stop moving the bucket 1002 and boom 1004, or to lower the bucket 1002 and boom 1004 away from the conductor 28 or causes the motor 32 to shut down thereby stopping movement of the bucket 1002 and boom 1004; in some embodiments, this occurs automatically by the emergency stop circuit 182 in response to the detection of overvoltage. In some embodiments, when the emergency stop button 67 is activated by the operator, the motor 32 is stopped thereby stopping movement of the bucket 1002 and boom 1004, or the motor 32 is shut down thereby stopping movement of the bucket 1002 and boom 1004. In some embodiments, the engine of the bucket truck 1000 is shut down when the bucket truck 1000 acts or when the operator activates the emergency stop button 67.

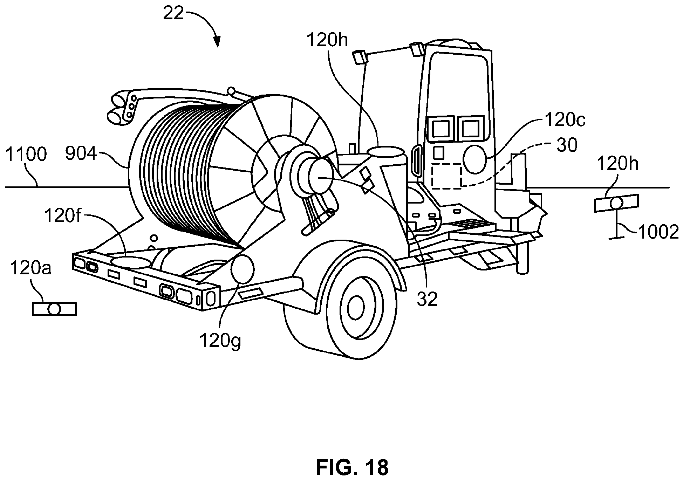

While the electric field detectors 120a-n are described as being provided on or part of the equipment 22, additional electric field detectors 120a-n may be provided around the equipment 22 and communicate with the electric field detectors 120a-n on the equipment 22 and may communicate with the control system 30 of the equipment 22. FIG. 18 illustrates this situation with the puller/tensioner vehicle 600 being shown for illustrative purposes only. As an example, additional electric field detectors 120a-n can be positioned on the ground 1100 by the equipment 22, be placed on the ground under the equipment 22, be positioned on a pole or a cone and/or other stand 1002 surrounding the equipment 22. The electric field detectors 120a-n can help to establish a safe working perimeter around the work area.

While the voltage threshold is described herein as a voltage meeting a certain voltage, the system could be modified to provide a warning if no voltage is detected.

In some embodiments, the electric field detectors 120a-n and/or equipment 22 can additionally or alternatively communicate via the communication modules 158, 62 with various computing devices including but not limited to, smart phones, tablets, laptops, personal computers (PC), etc., with communication capability and which may operate on one of a variety of operating systems including but not limited to Microsoft Windows (a registered trademark of Microsoft Corporation), Apple iOS (a registered trademark of Cisco), Apple OSX, Google Android (a registered trademark of Google Inc.), or Linux (a registered trademark owned by Linus Torvalds) to provide warnings to the operators. In some embodiments, the electric field detector 120a-n and/or equipment 22 can communicate the detected overvoltage to devices not in the area, e.g., a supervisor working in an office located away from the work site, and/or an emergency response unit, etc. In such embodiments, communication between an electric field detector 120 or equipment 22 and another computing device can be via any form of communication that may be supported by communication modules 158, 62, including various wireless communication technology (e.g., various WLAN, PAN, cellular technologies) and/or communication via various physical connections (e.g., USB, FireWire, Thunderbolt, etc.).

The processing capability of the systems and processes described herein may be distributed among multiple system components, such as among multiple processors and memories, optionally including multiple distributed processing systems. Parameters, databases, and other data structures may be separately stored and managed, may be incorporated into a single memory or database, may be logically and physically organized in many different ways, and may implemented in many ways, including data structures such as linked lists, hash tables, or implicit storage mechanisms. Programs may be parts (e.g., subroutines) of a single program, separate programs, distributed across several memories and processors, or implemented in many different ways, such as in a library, such as a shared library (e.g., a dynamic link library (DLL)). The DLL, for example, may store code that performs any of the system processing described above. The systems and methods can be implemented over a cloud. While particular embodiments are illustrated in and described with respect to the drawings, it is envisioned that those skilled in the art may devise various modifications without departing from the scope of the appended claims. It will therefore be appreciated that the scope of the disclosure and the appended claims is not limited to the specific embodiments illustrated in and discussed with respect to the drawings and that modifications and other embodiments are intended to be included within the scope of the disclosure and appended claims. Moreover, although the foregoing descriptions and the associated drawings describe example embodiments in the context of certain example combinations of elements and/or functions, it should be appreciated that different combinations of elements and/or functions may be provided by alternative embodiments without departing from the scope of the disclosure and the appended claims.

## Claims

1. A system comprising:
a piece of equipment (22) comprising a component (26) configured to come into direct contact with a conductor (28) of electricity or come into proximity of a conductor of electricity, and a control system (30) which is in operative communication with the component and which is configured to control operation of the component; and
an electric field detector (120a-n) on the equipment, the electric field detector comprising field detection circuitry (142) configured to detect a voltage in an electric field in the environment which meets or exceeds a voltage threshold, the field detection circuitry being in communication with the control system of the piece of equipment,
wherein when an overvoltage is detected by the electric field detector, the control system of the equipment is configured to act by performing one of 1) activating a warning module (152) on the equipment and 2) causing the component of the equipment to act, **characterized in that** a plurality of the electric field detectors are on the equipment, the electric field detectors being in communication with each other and with the control system and that when one of the plurality of the electric field detectors detect an overvoltage, the electric field detector that detects the overvoltage is configured to send a warning notification to the other field detectors.

2. The system of claim 1, wherein when the overvoltage is detected by the electric field detector, the control system of the equipment is configured to act by performing both of 1) activating a warning module on the equipment and 2) causing the component of the equipment to act.

3. The system of claim 2, wherein the piece of equipment further comprises a user interface (65), and wherein when the overvoltage is detected by the electric field detector, the control system of the equipment is configured to act by further activating a warning on the user interface.

4. The system of claim 1, wherein the piece of equipment further comprises a user interface, and wherein when the overvoltage is detected by the electric field detector, the control system of the equipment is configured to act by further activating a warning on the user interface.

5. The system according to one of the proceeding claims, **characterized in that** the electric field detector that detects the overvoltage is configured to send a warning notification to the control system.

6. The system of claim 5, wherein the electric field detectors and the control system are wirelessly connected to each other.

7. The system of claim 5, wherein the electric field detectors and the control system are connected to each other via a wired connection.

8. The system of claim 5, wherein when the control system of the equipment is configured to act by causing the component of the equipment to act, operation of the equipment is stopped.

9. The system of claim 1, wherein the electric field detector further comprises a warning module in communication with the field detection circuitry, wherein the field detection circuitry is configured to activate the warning module when an overvoltage is detected by the field detection circuitry.

10. The system of claim 1, wherein the component includes a motor.

11. The system of claim 1, wherein the equipment further comprises wheels.

12. The system of claim 1, wherein the equipment is mounted on the ground.

13. A method of operating a piece of equipment comprising:
providing an electric field detector on the piece of equipment;
wherein when a component of the piece of equipment comes into direct contact with a conductor of electricity or comes into proximity of a conductor of electricity:
1) the electric field detector detects a voltage in an electric field which meets or exceeds a voltage threshold,
2) and in response, the electric field detector sends a notification to a control system of the equipment, and
3) the control system of the equipment activates a warning module on the equipment, **characterized in that** the equipment will be provided with a plurality of electric field detectors, the electric field detectors being in communication with each other and with the control system and when one of the plurality of the electric field detectors detects an overvoltage the electric field detector that detects the overvoltage sends a warning notification to the other electric field detectors and preferably, the control system of the equipment stops operation of the equipment.

14. A method according to claim 13, **characterized in that** the electric detector detecting a voltage in an electric field which meets or exceeds the voltage threshold sends in response a notification to the control system of the equipment and the control system of the equipment stops operation of the equipment.

15. The method of claim 14, further comprising activating a warning module on the equipment, and/or wherein, preferably, the warning is at least one of an audio warning and a visual warning and/or wherein different warnings are provided for electric fields having differing strengths.

## Patentansprüche

1. Ein System, das Folgendes umfasst:
ein Gerät (22), das eine Komponente (26) umfasst, die so konfiguriert ist, dass sie in direkten Kontakt mit einem elektrischen Leiter (28) oder in die Nähe eines elektrischen Leiters kommt, und ein Steuersystem (30), das in operativer Kommunikation mit der Komponente steht und das so konfiguriert ist, dass es den Betrieb der Komponente steuert; und
einen Detektor für elektrische Felder (120a-n) an dem Gerät, wobei der Detektor für elektrische Felder eine Felderfassungsschaltung (142) umfasst, die so konfiguriert ist, dass sie eine Spannung in einem elektrischen Feld in der Umgebung erfasst, die einen Spannungsschwellenwert erreicht oder überschreitet, wobei die Felderfassungsschaltung mit dem Steuersystem des Geräts in Verbindung steht,
wobei, wenn eine Überspannung durch den elektrischen Felddetektor detektiert wird, das Steuersystem des Geräts so konfiguriert ist, dass es handelt, indem es entweder 1) ein Warnmodul (152) auf dem Gerät aktiviert oder 2) die Komponente des Geräts zum Handeln veranlasst, **dadurch gekennzeichnet, dass** sich eine Vielzahl der elektrischen Felddetektoren auf dem Gerät befindet, wobei die elektrischen Felddetektoren miteinander und mit dem Steuersystem in Verbindung stehen, und dass, wenn einer der Vielzahl der elektrischen Felddetektoren eine Überspannung detektiert, der elektrische Felddetektor, der die Überspannung detektiert, so konfiguriert ist, dass er eine Warnmeldung an die anderen Felddetektoren sendet.

2. System nach Anspruch 1, wobei, wenn die Überspannung von dem elektrischen Felddetektor erfasst wird, das Steuersystem des Geräts so konfiguriert ist, dass es handelt, indem es sowohl 1) ein Warnmodul an dem Gerät aktiviert als auch 2) die Komponente des Geräts zum Handeln veranlasst.

3. System nach Anspruch 2, wobei das Gerät weiter eine Benutzerschnittstelle (65) umfasst, und wobei, wenn die Überspannung durch den Detektor für elektrische Felder erfasst wird, das Steuersystem des Geräts so konfiguriert ist, dass es handelt, indem es eine Warnung auf der Benutzerschnittstelle aktiviert.

4. System nach Anspruch 1, wobei das Gerät weiter eine Benutzerschnittstelle umfasst, und wobei, wenn die Überspannung durch den Detektor für elektrische Felder erfasst wird, das Steuersystem des Geräts so konfiguriert ist, dass es weiter eine Warnung auf der Benutzerschnittstelle aktiviert.

5. Das System nach einem der vorangehenden Ansprüche, **dadurch gekennzeichnet, dass** der Detektor für elektrische Felder, der die Überspannung erfasst, so konfiguriert ist, dass er eine Warnmeldung an das Steuersystem sendet.

6. System nach Anspruch 5, wobei die elektrischen Felddetektoren und das Steuersystem drahtlos miteinander verbunden sind.

7. System nach Anspruch 5, bei dem die elektrischen Felddetektoren und das Steuersystem über eine Kabelverbindung miteinander verbunden sind.

8. System nach Anspruch 5, wobei der Betrieb des Geräts gestoppt wird, wenn das Steuersystem des Geräts so konfiguriert ist, dass es die Komponente des Geräts zum Handeln veranlasst.

9. System nach Anspruch 1, wobei der Detektor für elektrische Felder weiter ein Warnmodul umfasst, das mit der Felderfassungsschaltung kommuniziert, wobei die Felderfassungsschaltung so konfiguriert ist, dass sie das Warnmodul aktiviert, wenn eine Überspannung durch die Felderfassungsschaltung erfasst wird.

10. System nach Anspruch 1, wobei die Komponente einen Motor umfasst.

11. System nach Anspruch 1, wobei die Ausrüstung ferner Räder umfasst.

12. System nach Anspruch 1, wobei die Ausrüstung auf dem Boden montiert ist.

13. Verfahren zum Betreiben eines Ausrüstungsgegenstandes, umfassend:
Bereitstellen eines Detektors für elektrische Felder an dem Gerät;
wobei, wenn eine Komponente des Geräts in direkten Kontakt mit einem elektrischen Leiter oder in die Nähe eines elektrischen Leiters kommt:
1) der Detektor für elektrische Felder eine Spannung in einem elektrischen Feld erfasst, die eine Spannungsschwelle erreicht oder überschreitet,
2) und als Reaktion darauf der Detektor für elektrische Felder eine Meldung an ein Steuersystem des Geräts sendet, und
3) das Steuersystem des Geräts ein Warnmodul auf dem Gerät aktiviert, **dadurch gekennzeichnet, dass** das Gerät mit einer Vielzahl von elektrischen Felddetektoren versehen ist, wobei die elektrischen Felddetektoren miteinander und mit dem Steuersystem in Verbindung stehen, und wenn einer der Vielzahl der elektrischen Felddetektoren eine Überspannung detektiert, der elektrische Felddetektor, der die Überspannung detektiert, eine Warnmeldung an die anderen elektrischen Felddetektoren sendet und vorzugsweise das Steuersystem des Geräts den Betrieb des Geräts stoppt.

14. Verfahren nach Anspruch 13, **dadurch gekennzeichnet, dass** der elektrische Detektor, der eine Spannung in einem elektrischen Feld detektiert, die den Spannungsschwellenwert erreicht oder überschreitet, als Antwort eine Benachrichtigung an das Steuersystem des Geräts sendet und das Steuersystem des Geräts den Betrieb des Geräts stoppt.

15. Verfahren nach Anspruch 14, ferner umfassend das Aktivieren eines Warnmoduls an dem Gerät, und/oder, vorzugsweise, die Warnung mindestens eine akustische Warnung und/oder eine akustische Warnung ist.

## Revendications

1. Un système comprenant:
un élément d'équipement (22) comprenant un composant (26) configuré pour venir en contact direct avec un conducteur d'électricité (28) ou venir à proximité d'un conducteur d'électricité, et un système de commande (30) qui est en communication fonctionnelle avec le composant et qui est configuré pour commander le fonctionnement du composant; et
un détecteur de champ électrique (120a-n) sur l'équipement, le détecteur de champ électrique comprenant un circuit de détection de champ (142) configuré pour détecter une tension dans un champ électrique dans l'environnement qui atteint ou dépasse un seuil de tension, le circuit de détection de champ étant en communication avec le système de commande de l'élément d'équipement,
dans lequel, lorsqu'une surtension est détectée par le détecteur de champ électrique, le système de commande de l'équipement est configuré pour agir en effectuant l'un parmi: 1) l'activation d'un module d'avertissement (152) sur l'équipement et 2) l'action d'amener le composant de l'équipement à agir, **caractérisé en ce qu'**une pluralité de détecteurs de champ électrique sont sur l'équipement, les détecteurs de champ électrique étant en communication les uns avec les autres et avec le système de commande et **en ce que**, lorsque l'un de la pluralité de détecteurs de champ électrique détecte une surtension, le détecteur de champ électrique qui détecte la surtension est configuré pour envoyer une notification d'avertissement aux autres détecteurs de champ.

2. Le système de la revendication 1, dans lequel lorsque la surtension est détectée par le détecteur de champ électrique, le système de commande de l'équipement est configuré pour agir en effectuant à la fois 1) l'activation d'un module d'avertissement sur l'équipement et 2) l'action d'amener le composant de l'équipement à agir.

3. Le système de la revendication 2, dans lequel l'élément d'équipement comprend en outre une interface utilisateur (65), et dans lequel lorsque la surtension est détectée par le détecteur de champ électrique, le système de commande de l'équipement est configuré pour agir en activant en outre un avertissement sur l'interface utilisateur.

4. Le système de la revendication 1, dans lequel l'élément d'équipement comprend en outre une interface utilisateur, et dans lequel, lorsque la surtension est détectée par le détecteur de champ électrique, le système de commande de l'équipement est configuré pour agir en activant en outre un avertissement sur l'interface utilisateur.

5. Le système selon l'une des revendications précédentes, **caractérisé en ce que** le détecteur de champ électrique qui détecte la surtension est configuré pour envoyer une notification d'avertissement au système de commande.

6. Le système de la revendication 5, dans lequel les détecteurs de champ électrique et le système de commande sont connectés sans fil entre eux.

7. Le système de la revendication 5, dans lequel les détecteurs de champ électrique et le système de commande sont connectés entre eux par une connexion filaire.

8. Le système de la revendication 5, dans lequel lorsque le système de commande de l'équipement est configuré pour agir en amenant le composant de l'équipement à agir, le fonctionnement de l'équipement est arrêté.

9. Le système de la revendication 1, dans lequel le détecteur de champ électrique comprend en outre un module d'avertissement en communication avec le circuit de détection de champ, dans lequel le circuit de détection de champ est configuré pour activer le module d'avertissement lorsqu'une surtension est détectée par le circuit de détection de champ.

10. Le système de la revendication 1, dans lequel le composant comprend un moteur.

11. Le système de la revendication 1, dans lequel l'équipement comprend en outre des roues.

12. Le système de la revendication 1, dans lequel l'équipement est monté sur le sol.

13. Un procédé de fonctionnement d'un élément d'équipement comprenant:
la fourniture d'un détecteur de champ électrique sur l'élément d'équipement;
dans lequel, lorsqu'un composant de la pièce d'équipement vient en contact direct avec un conducteur d'électricité ou vient à proximité d'un conducteur d'électricité:
1) le détecteur de champ électrique détecte une tension dans un champ électrique qui atteint ou dépasse un seuil de tension,
2) et en réponse, le détecteur de champ électrique envoie une notification à un système de commande de l'équipement, et
3) le système de commande de l'équipement active un module d'avertissement sur l'équipement, **caractérisé en ce que** l'équipement sera pourvu d'une pluralité de détecteurs de champ électrique, les détecteurs de champ électrique étant en communication les uns avec les autres et avec le système de commande et lorsque l'un de la pluralité des détecteurs de champ électrique détecte une surtension, le détecteur de champ électrique qui détecte la surtension envoie une notification d'avertissement aux autres détecteurs de champ électrique et de préférence, le système de commande de l'équipement arrête le fonctionnement de l'équipement.

14. Le procédé selon la revendication 13, **caractérisé en ce que** le détecteur électrique détectant une tension dans un champ électrique qui atteint ou dépasse le seuil de tension envoie en réponse une notification au système de commande de l'équipement et le système de commande de l'équipement arrête le fonctionnement de l'équipement.

15. Le procédé de la revendication 14, comprenant en outre l'activation d'un module d'avertissement sur l'équipement, et/ou dans lequel, de préférence, l'avertissement est au moins l'un parmi un avertissement sonore et d'un avertissement visuel et/ou dans lequel différents avertissements sont fournis pour des champs électriques ayant des forces différentes.
